**Europäisches Patentamt**

**European Patent Office**

**Office européen des brevets**

(19)

(11) Numéro de publication: **0 022 687**
**B1**

(12) # FASCICULE DE BREVET EUROPEEN

(45) Date de publication du fascicule du brevet:
**20.07.83**

(51) Int. Cl.³: **H 01 L 27/06**, H 01 L 27/08

(21) Numéro de dépôt: **80400834.0**

(22) Date de dépôt: **10.06.80**

(54) Circuit intégré monolithique équivalent à un transistor associé à trois diodes anti-saturation et son procédé de fabrication.

(30) Priorité: **12.06.79 FR 7914996**

(43) Date de publication de la demande:
**21.01.81 Bulletin 81/3**

(45) Mention de la délivrance du brevet:
**20.07.83 Bulletin 83/29**

(84) Etats contractants désignés:
**DE GB IT NL**

(56) Documents cités:
**FR-A-2 101 228**
**FR-A-2 282 721**
**US-A-4 072 981**
**US-A-4 138 690**

(73) Titulaire: **THOMSON-CSF, 173, Boulevard Haussmann,**
**F-75379 Paris Cedex 08 (FR)**

(72) Inventeur: **Quoirin, Jean-Baptiste, "THOMSON-CSF"**
**SCPI 173, bld Haussmann, F-75360 Paris Cedex 08 (FR)**

(74) Mandataire: **de Beaumont, Michel et al, THOMSON-CSF**
**SCPI 173, Bld Haussmann, F-75379 Paris Cedex 08 (FR)**

ACTORUM AG

# Circuit intégré monolithique équivalent à un transistor associé à trois diodes anti-saturation et son procédé de fabrication

La présente invention concerne une structure intégrée comprenant un montage à transistor, le transistor d'entrée étant muni de diodes anti-saturation, ainsi que le procédé de fabrication d'une telle structure.

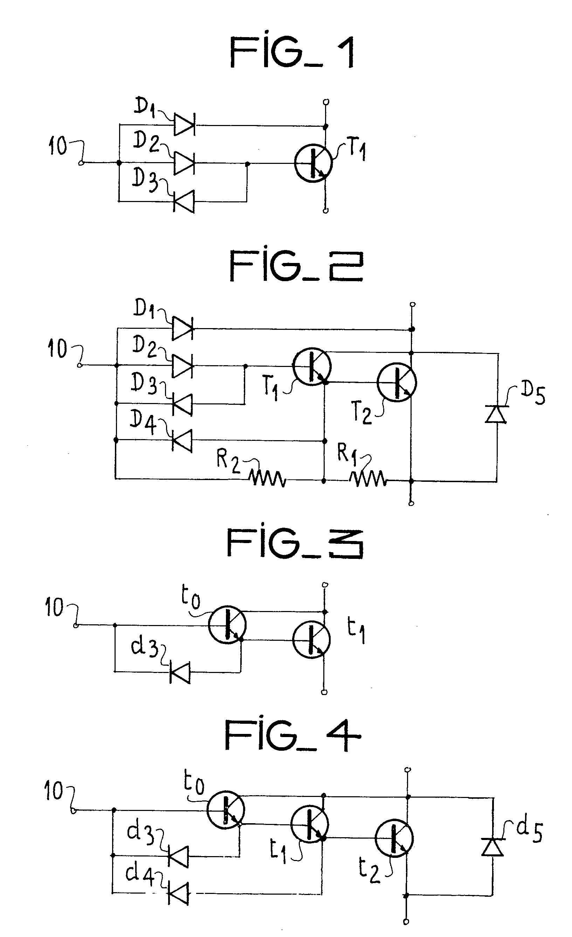

Il est connu dans la technique que pour améliorer certaines caractéristiques d'un transistor, notamment pour des transistors de puissance fonctionnant en commutation, il peut être souhaitable d'associer à ce transistor trois diodes, dites diodes d'anti-saturation, connectées de la façon représentée en figure 1. L'entrée vers la base du transistor NPN T1 se fait par l'intermédiaire de deux diodes en antiparallèle D2 et D3. Cette entrée est connectée au collecteur du transistor T1 par l'intermédiaire d'une diode D1 orientée de la façon représentée dans la figure.

Cette prévision de diodes anti-saturation s'applique également, comme cela est connu dans la technique, au cas d'un montage Darlington comme cela est représenté dans la figure 2. On peut voir dans cette figure, outre les éléments déjà décrits en relation avec la figure 1, un transistor T2 dont la base est reliée à l'émetteur du transistor T1 et le collecteur au collecteur du transistor T1, cette connexion commune de collecteur servant de sortie collecteur du montage et l'émetteur du transistor T2 servant de sortie d'émetteur du montage Darlington. De façon générale, il est également prévu une résistance R1 entre les émetteurs des transistors T1 et T2, une résistance R2 entre l'émetteur du transistor T1 et l'entrée 10 du circuit et une diode de sortie D5. En outre, entre collecteur et émetteur, une diode D4, couramment appelée diode de déstockage, est souvent incluse dans un montage Darlington entre l'émetteur et la base du transistor T1 (ou plutôt, dans le cas particulier représenté, l'entrée 10) pour diminuer le temps de stockage du circuit.

On connaît dans la technique, par exemple d'après le brevet américain 4 072 981, des circuits incluant les transistors T1, T2 et les diodes D4 et D5 sous forme intégrée.

La présente invention a pour objet de prévoir un circuit intégré monolithique incluant le transistor T1 et l'ensemble de ses diodes d'anti-saturation D1, D2, D3, cette intégration étant compatible avec l'intégration d'un ensemble Darlington comme dans le cas de la figure 2. Dans la pratique, chacune des diodes D1, D2, D3 et D4 peut en fait être constituée de plusieurs diodes en série.

L'invention se base sur une analyse détaillée et comparative entre un transistor muni de ses diodes antisaturation tel que le transistor T1 de la figure 1 et un montage Darlington avec diode de déstockage tel qu'il est représenté en figure 3. Un montage Darlington est constitué de l'association de deux transistors t0 et t1, le transistor t1 étant un transistor de puissance et le transistor t0 un transistor de commande. Ces transistors sont connectés en collecteur commun; la base du transistor t0 sert d'entrée au circuit; l'émetteur du transistor t0 est connecté à la base du transistor t1; et l'émetteur du transistor t1 sert de sortie d'émetteur au montage. En outre, il est généralement prévu pour améliorer la rapidité de commutation de l'ensemble une diode d3 dite diode de déstockage montée de la façon représentée entre émetteur et base du transistor de commande t0. Dans la pratique courante des montages Darlington, le gain du transistor t0 est choisi à une valeur nettement supérieure à l'unité étant donné que le gain du transistor d'ensemble est sensiblement égal au produit des deux gains des transistors t0 et t1. L'invention se base sur l'appréciation du fait que les schémas des figures 1 et 3 sont strictement équivalents dans le cas où le gain du transistor t0 est nettement inférieur à l'unité. Alors, ce transistor t0 devient équivalent à l'ensemble des diodes d1 et d2 représentées en figure 1. Ainsi, la présente invention prévoit un circuit intégré monolithique équivalent à un transistor associé à trois diodes anti-saturation comprenant deux transistors en montage Darlington et une diode de déstockage, le gain du premier transistor étant inférieur à l'unité. Pour réduire le gain de ce premier transistor et augmenter la rapidité de la diode de déstockage D3, la présente invention prévoit la fabrication normale d'un montage Darlington, tel que représenté en figure 3, avec en cours du processus une étape de fabrication propre à diminuer un des deux paramètres physiques responsables de la valeur du gain dans une structure transistor.

Ces deux paramètres sont la durée de vie des porteurs minoritaires dans la base d'une part, le coefficient d'injection de la jonction émetteur-base d'autre part.

On effectue la diminution de la durée de vie par une diffusion d'or ou une irradiation (aux électrons, aux rayons X ou $\gamma$) dans la zone occupée par le transistor t0 et la diode d3. Des procédés de ce type sont par exemple décrits dans le brevet américain 4 138 690.

On peut procéder à la diminution du coefficient d'injection essentiellement de deux façons: ou bien la base est diffusée avec une très forte concentration en dopant, d'une valeur telle que le rapport de la quantité de dopant utilisé pour l'émetteur sur la quantité de dopant utilisé dans la base n'excède pas un facteur 10; ou bien on remplace la zone d'émetteur N (ou P) par un caisson en silicium polycristallin dopé selon une impureté N (ou P), la nature polycristalline de l'émetteur inhibant d'une façon sensible le mécanisme d'injection des porteurs. Des procédés de ce type sont enseignés par le brevet français 2 101 228.

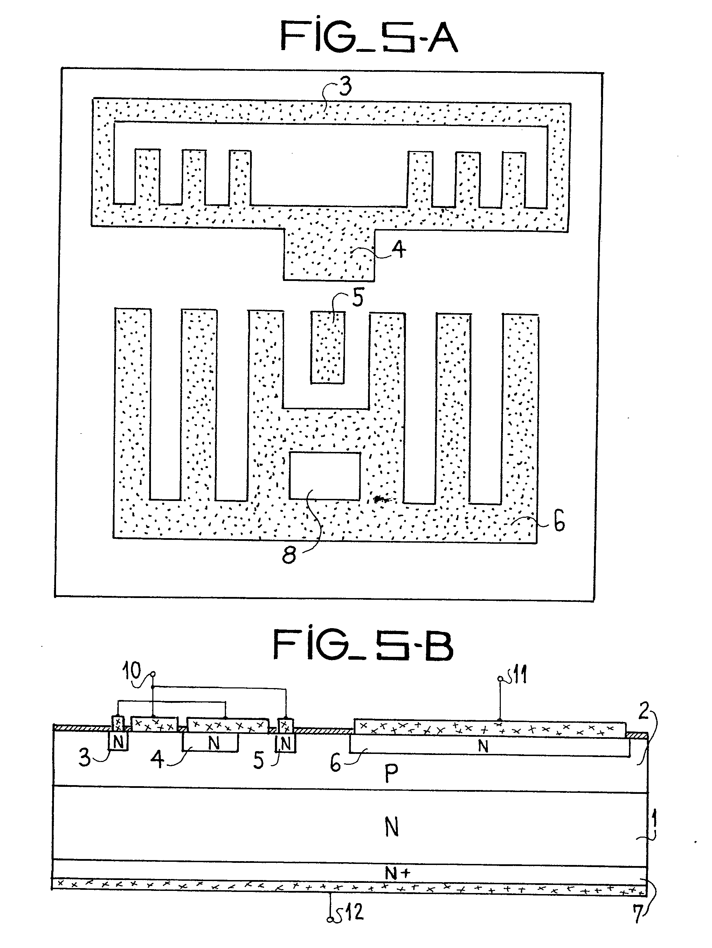

Le circuit de la figure 3, après avoir subi le traitement de réduction de durée de vie ou du coefficient d'injection, devient équivalent à un transistor T1 équipé de trois diodes anti-saturation. Si l'on souhaite obtenir un montage Darlington dans lequel le premier transistor est équipé de diodes anti-saturation, il conviendra de rajouter derrière le transistor t1, un transistor t2 monté par rapport à ce transistor t1 en montage Darlington, une diode d4 servant de diode anti-saturation pour ce montage. On obtient alors le schéma représenté en figure 4 dans lequel des éléments équivalents à ceux de la figure 3 sont désignés par de mêmes références alphanumériques.

Un avantage de la présente invention réside dans le fait que l'on fait usage des techniques bien connues pour intégrer des montages Darlington et que l'on modifie ces structures de façon à réduire le gain dans une zone prédéterminée pour obtenir un transistor équipé de diodes anti-saturation. La description de modes de réalisation particuliers de la présente invention effectuée ci-après permettra de montrer la simplicité de fabrication de structures de transistors équipés de diodes anti-saturation selon la présente invention.

Ces objets, caractéristiques et avantages ainsi que d'autres de la présente invention seront exposés plus en détail dans la description suivante de modes de réalisation particuliers faite en relation avec les figures jointes parmi lesquelles:

les figures 1 et 2 représentent sous forme symbolique des circuits que vise à réaliser la structure intégrée selon la présente invention;

les figures 3 et 4 représentent des circuits respectivement équivalents aux circuits des figures 1 et 2 selon la présente invention;

les figures 5A et 5B représentent respectivement une vue de dessus et une vue en coupe schématique d'un transistor associé à ses trois diodes anti-saturation selon la présente invention;

les figures 6A et 6B représentent respectivement une vue de dessus et une vue en coupe d'un montage Darlington dans lequel le transistor d'entrée est associé à trois diodes anti-saturation.

On notera que, dans les divers figures, comme cela est classique dans la représentation schématique de dispositifs à semiconducteur, ni les épaisseurs, ni les dimensions relatives des diverses couches et surfaces ne sont tracées à l'échelle. Pour une réalisation pratique, l'homme de l'art se référera aux connaissances technologiques usuelles dans le domaine considéré.

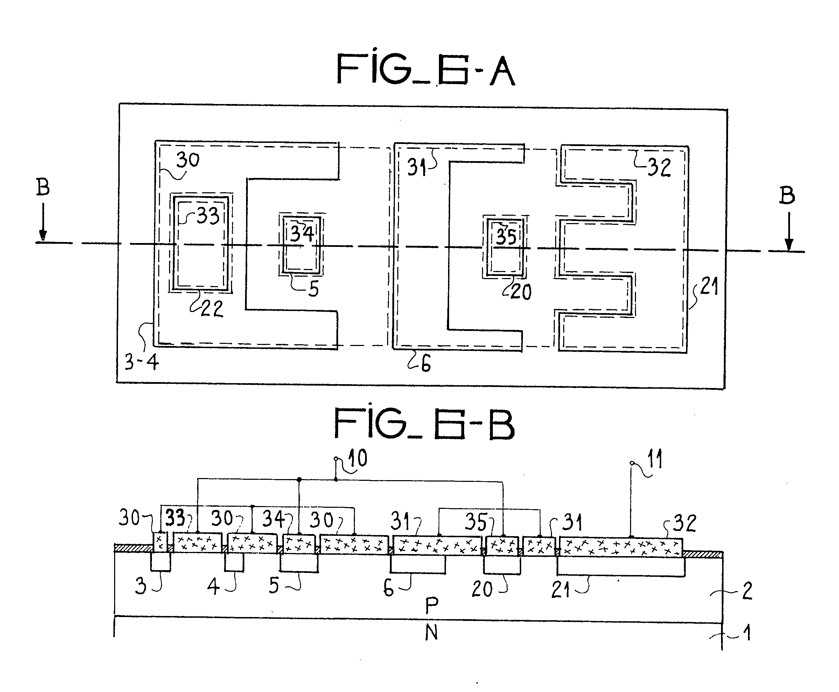

La figure 5B représente une vue en coupe schématique d'une structure intégrée selon la présente invention mettant en oeuvre le circuit de la figure 3 équivalent au circuit de la figure 1. On reconnaît une vue en coupe d'un montage Darlington classique. La borne 10 est la borne d'entrée, la borne 11 la borne d'émetteur et la borne 12 la borne de collecteur. Sur la face supérieure d'un substrat de type N, on forme une structure collecteur N/N$^+$, soit par épitaxie de la couche N en partant d'un substrat N$^+$, soit par diffusion d'une couche N$^+$ dans un matériau N (Technologie Triple diffusé). La base de type P est formée soit par épitaxie P soit par diffusion. On effectue ensuite simultanément des diffusions de type N à travers un masque sur la surface supérieure pour former des zones de type N 3, 4, 5 et 6. Si la base a été faite par épitaxie, on peut aussi continuer en faisant croître sur la couche P une troisième couche épitaxiée N dans laquelle on fait les caissons N 3, 4, 5 et 6 par diffusion (Technologie dit du LEC : low Emitter Concentration). Les zones de type N 3 et 4 correspondant à l'émetteur du premier transistor t0 (voir figure 3) la zone de type N 5 correspond à la diode anti-saturation d3 et la zone de type N 6 correspond à l'émetteur du transistor t1. Dans les figures, les couches hachurées correspondent à des couches de silice ou autres éléments de masquage et de passivation et les couches marquées d'une croix à des métallisations. On se référera à la figure pour déterminer schématiquement les contacts établis par ces couches de métallisation, étant entendu que ceci est de façon générale connu pour le réalisation de montages de type Darlington. Ensuite, selon l'invention, toute la partie supérieure gauche de la structure est traitée pour réduire le gain des structures transistors verticales à l'aplomb des couches N 3, 4 et 5.

Divers procédés peuvent être utilisés pour réaliser cette réduction du gain des transistors jusqu'à une valeur inférieure à 1. Si l'on choisit de diminuer la durée de vie des porteurs, on pourra procéder à une diffusion d'or localisée avant la réalisation des métallisations, ou bien on pourra procéder par irradiation électronique, ou encore aux rayons X ou $\gamma$. Dans ces derniers cas, le traitement pourra être effectué à travers les métallisations. Dans les deux cas, il conviendra de masquer avant le traitement, la partie supérieure de la structure correspondant à la zone d'émetteur 6 pour maintenir le gain du transistor t1. Si l'on choisit de diminuer le coefficient d'injection, il faut surdoper la base du transistor t0 et ceci peut se faire avant, pendant ou après la diffusion de la base commune des transistors t0 et t1 selon les caractéristiques physiques de cette base et la nature des dopants utilisés. Dans le cas où l'on se refuse à surdoper localement la zone de base tout en voulant diminuer le coefficient d'injection, on peut faire un dépôt localisé de silicium polycristallin dopé à l'emplacement de l'émetteur du transistor t0 et de la diode de déstockage. Tous les procédés énumérés (diffusion d'or localisée, irradiation localisée, surdopage de la base, émetteur polycristallin dopé) qui réalisent localement des structures transistor à gain inférieur à 1 sont connus dans la technique et ne seront pas décrits en détail ici.

La vue de dessus de la figure 5A ne constitue qu'un exemple de réalisation de la présente invention. On pourra se référer aux diverses structures Darlington connues et les traiter selon l'invention pour diminuer le gain du transistor d'entrée ou transistor de commande. La zone 8 dans l'émetteur 6 du transistor t1 correspond à une réserve propre à former une diode analogue à la diode d5 de la figure 4.

La figure 6B représente une vue en coupe d'une structure intégrée selon la présente invention équivalente à un montage Darlington dans lequel le transistor d'entrée est associé à des diodes anti-saturation. Seule la partie supérieure du substrat 1 a été représentée. Dans cette figure, on a utilisé de mêmes références pour désigner des zones et couches analogues à celles déjà représentées en figure 5B. On retrouve notamment les zones 3, 4, 5 et 6. On peut en outre voir une zone de type N 20 correspondant à la diode de déstockage du transistor t2 (voir figure 4) et une zone 21 de type N correspondant à l'émetteur du transistor t2 et connectée à la borne d'émetteur 11.

Les diffusions 3 et 4 qui apparaissent comme deux diffusions distinctes en figure 6B sont en fait une seule et même diffusion reliée par une zone continue comme on peut le voir en figure 6A.

Dans la figure 6A, les zones diffusées de type N sont représentées par des contours en traits pleins.

La référence 3-4 désigne le contour de diffusion dont les vues en coupe correspondent aux zones 3 et 4. Une zone interne 22 n'est pas diffusée. Les contours des métallisations désignées par des références 30 à 35 sont indiqués par des traits en pointillés. Les métallisations 33, 34 et 35 recouvrant les zones 22, 5 et 20 sont en fait solidaires et passent au-dessus des autres métallisations sous-jacentes par l'intermédiaire d'une couche d'oxyde d'isolement. En outre, bien qu'ils ne soient pas représentés sur la figure 6A, les affleurements de jonction sont protégés par des couches d'oxyde pour éviter la mise en court-circuit des jonctions. Il est clair qu'en figure 6B, plusieurs métallisations apparaissant comme distinctes sont en fait une seule et même métallisation et sont désignées par de mêmes références numériques.

## Revendications

1. Circuit intégré monolithique équivalent à un transistor (T1) associé à trois diodes anti-saturation (D1, D2, D3), caractérisé en ce qu'il comprend deux transistors (to, t1) en montage Darlington et une diode de déstockage (d3), le gain du transistor de commande (tO) étant inférieur à l'unité.

2. Circuit intégré selon la revendication 1, caractérisé en ce que la zone correspondant au transistor de commande (to) et à la diode de déstockage (d3) est soumise à une diffusion d'or.

3. Circuit intégré selon la revendication 1, caractérisé en ce que la zone correspondant au premier transistor et à la diode de déstockage est soumise à une irradiation du type électrons, rayons x, rayons gamma.

4. Circuit intégré selon la revendication 1, caractérisé en ce que la zone de base correspondant au premier transistor (to) et à la sortie de la diode de déstockage (d3) comprend un surdopage sur toute son épaisseur.

5. Circuit intégré selon la revendication 1, caractérisé en ce que la zone d'émetteur correspondant au premier transistor (to) et à l'entrée de la diode de déstockage (d3) est constituée d'un matériau polycristallin dopé.

6. Circuit intégré selon l'une quelconque des revendications 1 à 5, caractérisé en ce qu'il comprend en outre un troisième transistor (t2) associé au deuxième (t1) selon un montage Darlington.

7. Circuit selon la revendication 6, caractérisé en ce qu'il comprend en outre une diode de déstockage (d4) associée au troisième transistor (t2), cette diode étant soumise au traitement défini dans l'une des revendications 2 à 5.

8. Procédé de fabrication d'un circuit intégré équivalent à un transistor (T1) et à ses trois diodes anti-saturation (D1, D2, D3), caractérisé en ce qu'il comprend les étapes suivantes:

— fabriquer de façon connue un circuit Darlington monolithique (tO, t1) avec une diode de déstockage (d3);

— réduire le gain du transistor de commande (to) à une valeur inférieure à un en agissant soit sur la durée de la vie des porteurs minoritaires, soit sur le coefficient d'injection dans les zones du transistor de commande (tO) et de la diode de déstockage (d3).

9. Procédé selon la revendication 8, caractérisé en ce que la réduction de durée de vie est obtenue par diffusion d'or.

10. Procédé selon la revendication 8, caractérisé en ce que la réduction de durée de vie est obtenue par irradiation.

11. Procédé selon la revendication 8, caractérisé en ce que la réduction du coefficient d'injection est obtenue par un surdopage localisé de la base.

12. Procédé selon la revendication 8, caractérisé en ce que la réduction du coefficient d'injection est obtenue par réalisation d'un émetteur en silicium polycristallin dopé.

## Patentansprüche

1. Integrierter monolithischer Schaltkreis der einem mit drei Sättigungsverhinderungsdioden (D1, D2, D3) verbundenen Transistor (T1) entspricht, dadurch gekennzeichnet, dass er aus zwei in Darlingtonschaltung geschalteten Transistoren (t0, t1) und einer Entspeicherungsdiode (d3) besteht, wobei der Verstärkungsfaktor des Steuertransistors (t0) kleiner ist als eine Einheit.

2. Integrierter Schaltkreis gemäss Anspruch 1, dadurch gekennzeichnet, dass der dem Steuertransistor (t0) und der Entspeicherungsdiode (d3) entsprechende Bereich einer Golddiffusion unterzogen ist.

3. Integrierter Schaltkreis gemäss Anspruch 1, dadurch gekennzeichnet, dass der dem ersten Transistor und der Entspeicherungsdiode einer Bestrahlung des Typs Elektronen, X-Strahlen, Gamma-Strahlen unterzogen ist.

4. Integrierter Schaltkreis gemäss Anspruch 1, dadurch gekennzeichnet, dass der dem ersten Transistor (t0) und dem Ausgang der Entspeicherungsdiode (d3) entsprechende Grundbreich eine Überdopierung auf seiner ganzen Dicke enthält.

5. Integrierter Schaltkreis gemäss Anspruch 1, dadurch gekennzeichnet, dass der dem Transistor (t0) und dem Eingang der Entspeicherungsdiode (d3) entsprechende Emittierbereich aus gedoptem Polykristallinmaterial gebildet ist.

6. Integrierter Schaltkreis gemäss einem der Ansprüche 1 bis 5, dadurch gekennzeichnet, dass er zusätzlich einen dritten Transistor (t2) enthält, der mit dem zweiten (t1) in Darlingtonschaltung geschaltet ist.

7. Integrierter Schaltkreis gemäss Anspruch 6, dadurch gekennzeichnet, dass er zusätzlich eine Entspeicherungsdiode (d4) enthält, die mit dem dritten Transistor (t2) geschaltet ist, wobei diese Diode der in einem der Ansprüche 2 bis 5 definierten Behandlung unterzogen wurde.

8. Herstellungsverfahren eines integrierten Schaltkreises, der einem Transistor (T1) und seinen drei Sättigungsverhinderungsdioden (D1, D2, D3) entspricht, dadurch gekennzeichnet, dass es die folgenden Schritte umfasst:

— nach bekannter Art eine monolithische Darlingtonschaltung (t0, t1) mit einer Entspeicherungsdiode herstellen,

— den Verstärkungsfaktor des Steuertransistors (t0) auf einen Wert kleiner als eins vermindern, indem man entweder auf die Lebensdauer der Minoritätsträger oder auf den Injektionskoeffizienten in den Bereichen des Steuertransistors (t0) und der Entspeicherungsdiode (d3) einwirkt.

9. Herstellungsverfahren gemäss Anspruch 8, dadurch gekennzeichnet, dass die Verminderung der Lebensdauer durch Golddiffusion erzielt wird.

10. Herstellungsverfahren gemäss Anspruch 8, dadurch gekennzeichnet, dass die Verminderung der Lebensdauer durch Bestrahlung erzielt wird.

11. Herstellungsverfahren gemäss Anspruch 8, dadurch gekennzeichnet, dass die Verminderung des Injektionskoeffizienten durch örtliches Überdopen der Basis erzielt wird.

12. Herstellungsverfahren gemäss Anspruch 8, dadurch gekennzeichnet, dass die Verminderung des Injektionskoeffizienten durch Herstellung eines Emitters aus gedoptem Polykristallinsilizium erreicht wird.

**Claims**

1. Integrated circuit in a monolithic design equivalent to a transistor (T1), associated to three anti-saturation diodes (D1, D2, D3), characterized in that it comprises two Darlington circuit transistors (to, t1) and a destocking diode (d3), the control transistor (to) gain being inferior to the unit.

2. Integrated circuit according to claim 1, characterized in that the region corresponding to control transistor (to) and to destocking diode (d3) is subjected to a diffusion of gold.

3. Integrated circuit according to claim 1, characterized in that the region corresponding to the first transistor and to the destocking diode is subjected to an electrons, X-rays, gamma rays type irradiation.

4. Integrated circuit according to claim 1, characterized in that the base region corresponding to the first transistor (to) and to the output of the destocking diode (d3) comprises an overdoping on its entire thickness.

5. Integrated circuit according to claim 1, characterized in that the emitter region corresponding to the first transistor (to) and to the input of the destocking diode (d3) is constituted by a doped polycristalline material.

6. Integrated circuit according to one of claims 1 to 5, characterized in that it comprises furthermore a third transistor (t2) associated to a second transistor (t1) according to a Darlington circuit.

7. A circuit according to claim 6, characterized in that it comprises, furthermore, a destocking diode (d4) associated to a third transistor (t2), this diode being subjected to the treatment defined in one of claims 2 to 5.

8. Process for manufacturing an integrated circuit equivalent to a transistor (T1) and to its three anti-saturation diodes (D1, D2, D3) characterized in that it comprises the following steps:
— continuous manufacture of a monolithic Darlington circuit (t0, t1) with a destocking diode (3);
— reduction of the control transistor (to) gain to a value inferior to the unit by acting either on the lifespan of the minority carriers, or on the injection coefficient in the control transistor (to) and destocking diode (d3) regions.

9. Process according to claim 8, characterized in that the reduction of the lifespan is obtained through diffusion of gold.

10. Process according to claim 8, characterized in that the lifespan reduction is obtained through irradiation.

11. Process according to claim 8, characterized in that the reduction of the injection coefficient is obtained through a localised overdoping of the base.

12. Process according to claim 8, characterized in that the reduction of the injection coefficient is obtained by realizing an emitter made of doped polycrystalline silicium.

# FIG_ 1

# FIG_2

# FIG_3

# FIG_4

# FIG_5-A

# FIG_5-B

# FIG_6-A

# FIG_6-B

0 022 687